Europäisches Patentamt

European Patent Office

Office européen des brevets

(19)

(11) EP 0 688 476 B1

# (12) FASCICULE DE BREVET EUROPEEN

(45) Date de publication et mention
de la délivrance du brevet:
**21.05.1997 Bulletin 1997/21**

(21) Numéro de dépôt: **94909168.0**

(22) Date de dépôt: **09.03.1994**

(51) Int Cl.6: **H03H 17/02**, H03H 17/06

(86) Numéro de dépôt international:
**PCT/FR94/00259**

**WO 94/21041 (15.09.1994 Gazette 1994/21)**

(54) **PROCEDE ET DISPOSITIF DE FILTRAGE D'UN SIGNAL TEMPOREL NUMERIQUE, ET APPLICATION A LA CORRECTION D'ECHOS DANS UN CANAL DE TRANSMISSION**

VERFAHREN UND VORRICHTUNG ZUM FILTERN EINES DIGITALEN ZEITSIGNALS UND ANWENDUNG FÜR ECHOKORREKTUR IN EINEM ÜBERTRAGUNGSKANAL

DIGITAL TIME SIGNAL FILTERING METHOD AND DEVICE FOR TRANSMISSION CHANNEL ECHO CORRECTION

(84) Etats contractants désignés:
**DE GB IT NL SE**

(30) Priorité: **10.03.1993 FR 9302977**

(43) Date de publication de la demande:
**27.12.1995 Bulletin 1995/52**

(73) Titulaires:
- **FRANCE TELECOM**
  **75015 Paris (FR)**
- **TELEDIFFUSION DE FRANCE - TDF (S.A.)**
  **75015 Paris 15 (FR)**

(72) Inventeurs:
- **PALICOT, Jacques**
  **F-35000 Rennes (FR)**
- **DJOKO KOUAM, Moise**
  **F-35700 Rennes (FR)**
- **VEILLARD, Jacques**
  **F-35760 Montgermont (FR)**

(74) Mandataire: **Ballot, Paul**
**Cabinet Ballot-Schmit**
**4, rue Général Hoche**
**Boîte Postale 855**
**56108 Lorient Cédex (FR)**

(56) Documents cités:
- **PROCEEDINGS 1987 INTERN. CONF. ON . ACOUS SPEECH, AND SIGNAL PROCESSING; 6-9 APRIL 1 P 2161-2164; DALLAS (US); J.P. PRINCEN et SUBBAND/TRANSFORM CODING FILTER BANK DESIG**
- **PROCEEDINGS 1987 INTERN. CONF. ON ACOUS. SPEECH, AND SIGNAL PROCESSING; 6-9 APRIL, 1987, pp 2161-2164; DALLAS (US); J.P. PRINCEN et al.: 'Subband/Transform Coding Using Filter Bank Designs Based on Time Domain Aliasing Cancellation'**

**Description**

L'invention concerne un procédé de filtrage numérique de signaux temporels tels que ceux reçus d'un canal de transmission ou d'un réseau de diffusion.

Elle concerne également un dispositif de filtrage numérique pour la mise en oeuvre du procédé.

L'invention trouve une application particulièrement intéressante pour réaliser la correction d'échos au niveau d'un récepteur relié à un système de transmission tel qu'un réseau de télévision.

D'une façon générale, un filtrage numérique concerne un signal temporel numérique, c'est-à-dire résultant d'un échantillonnage au rythme d'une certaine période d'échantillonnage T généralement imposée en fonction des besoins du traitement pour tenir compte par exemple d'une bande passante déterminée. Ainsi, par exemple, le signal vidéo conforme à la norme D2-MAC est échantillonné avec une période de 49,38 nanosecondes.

Le filtrage numérique d'un tel signal peut être effectué dans le domaine fréquentiel, c'est-à-dire à partir de la transformée de Fourier discrète du signal temporel numérique. Le filtrage est alors défini par une fonction de transfert également échantillonnée avec un certain pas d'échantillonnage en fréquence df. Cette fonction de transfert est donc la transformée de Fourier échantillonnée de la réponse impulsionnelle temporelle du filtre à réaliser.

Mathématiquement, le filtrage consiste à calculer à chaque période d'échantillonnage T le produit de convolution du signal temporel et de la réponse impulsionnelle du filtre. Le résultat de la convolution donne directement le signal filtré dans le domaine temporel. Si le filtre est défini par sa fonction de transfert dans le domaine fréquentiel, la convolution se ramène au simple produit (dans l'espace complexe) de la transformée de Fourier discrète du signal temporel à filtrer par la fonction de transfert du filtre pour chacune des valeurs de la fréquence pour lesquelles la fonction de transfert est définie. Le résultat de ce produit complexe fournit alors la transformée de Fourier discrète du signal filtré. Une transformation de Fourier discrète inverse permet de revenir dans le domaine temporel.

Pour que le filtre soit pratiquement réalisable, le nombre d'échantillons dans les domaines temporel et fréquentiel est évidemment limité. Il en résulte des conditions et des limitations concernant les domaines de définition des grandeurs temporelles et fréquentielles. Ainsi, conformément au théorème de SHANNON, l'échantillonnage temporel à la période T impose une limitation de la largeur de bande du signal pouvant être filtré. Cette première condition peut s'exprimer en disant que la fréquence d'échantillonnage 1/T d'un signal temporel réel doit être supérieure au double de sa bande passante DF. De même, l'échantillonnage dans le domaine fréquentiel implique une seconde condition : le signal temporel à filtrer n'est pris en compte que pendant un intervalle de temps limité DT de largeur au plus égale à l'inverse 1/df du pas d'échantillonnage df dans le domaine fréquentiel. L'intervalle maximum 1/df définit donc une fenêtre temporelle qui sera appelée par la suite "horizon temporel" du filtre.

La première des conditions précédentes sera respectée si on limite par filtrage la largeur de bande du signal temporel et/ou en choisissant une fréquence d'échantillonnage 1/T suffisamment élevée. La deuxième condition sera aussi respectée si le signal temporel peut être représenté par un nombre limité d'échantillons traités par le filtre à chaque période d'échantillonnage.

Si on utilise la transformation de Fourier discrète déjà évoquée ci-dessus, un nombre limité N d'échantillons dans le domaine temporel sert à calculer un même nombre N d'échantillons dans le domaine fréquentiel. Les deux conditions précédentes peuvent être alors résumées par les relations suivantes :

(1)      $T \leq 1/(2\ DF)$
(2)      $df \leq 1/DT$
(3)      $N.df \geq 2\ DF$
(4)      $N.T \geq DT$
où :

T     est la période d'échantillonnage temporel,
df    est le pas d'échantillonnage fréquentiel,
N     est le nombre d'échantillons servant pour la transformation de Fourier discrète,
DF   est la bande passante du signal temporel,
DT   est l'horizon temporel du filtre.

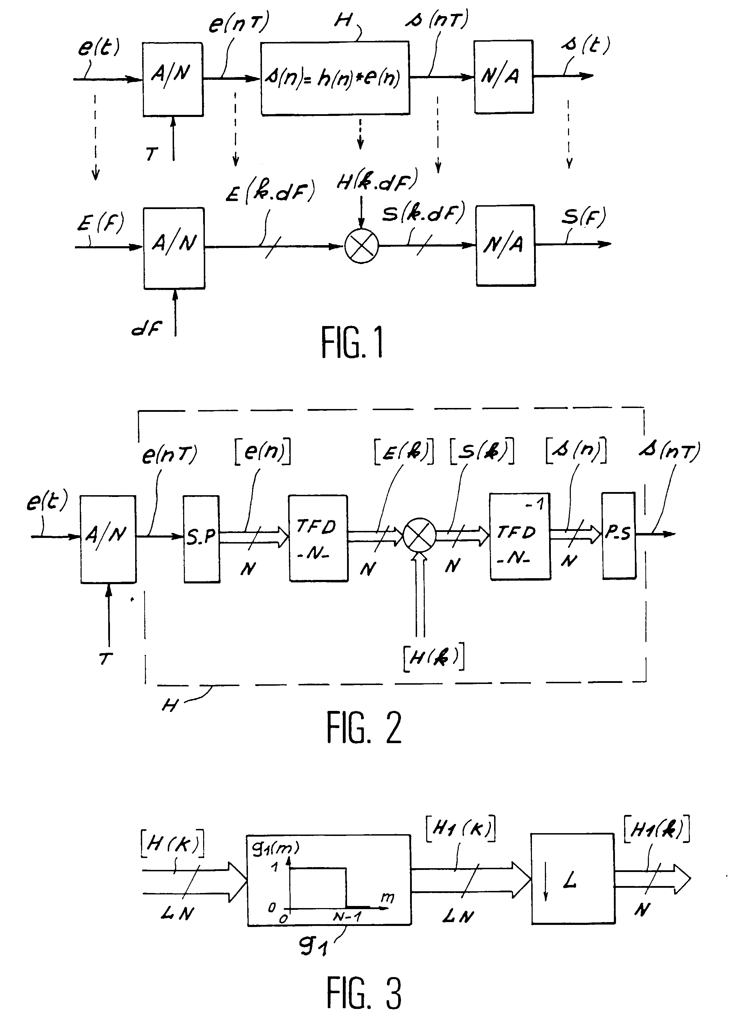

En théorie, une opération de filtrage d'un signal temporel au moyen d'un filtre numérique H est résumée à la figure 1 qui montre les opérations effectuées dans les domaines temporel et fréquentiel ainsi que les correspondances d'un domaine à l'autre. La partie supérieure de la figure fait apparaître les divers paramètres temporels impliqués par le filtrage tandis que la partie inférieure montre les paramètres correspondants (par transformation de Fourier) -dans le domaine fréquentiel.

Ainsi le signal temporel e(t) à filtrer (supposé continu) est échantillonné avec la période T et converti en grandeur numérique par le convertisseur A/N qui fournit le signal numérique échantillonné e(nT), où n est le rang de l'échantillon correspondant e(n). Le filtre H étant supposé défini par sa réponse impulsionnelle échantillonnée h(n), l'opération de filtrage consiste à calculer le produit de convolution :

$$s(n) = h(n)*e(n).$$

Le résultat de ce produit de convolution fournit le signal de sortie temporel échantillonné s(nT) du filtre. Une conversion numérique-analogique N/A de ce signal permet d'obtenir un signal de sortie analogique temporel s(t).

Le même filtrage est représenté dans le domaine fréquentiel dans la partie inférieure de la figure. Le signal d'entrée E(f) est le transformé du signal temporel e(t). Ce signal est échantillonné avec un pas d'échantillonnage df et converti en grandeur numérique par le convertisseur A/N qui fournit le signal fréquentiel échantillonné E(k.df). Le filtre H étant supposé défini dans le domaine fréquentiel, l'opération de filtrage consiste à réaliser le produit complexe des échantillons E(k.df) par les échantillons de même rang k de la fonction de transfert échantillonnée dans le domaine fréquentiel H(k.df). Les résultats de ces produits constituent la sortie échantillonnée dans le domaine fréquentiel S(k.df) du filtre. Une conversion numérique-analogique N/A permet de passer dans le domaine fréquentiel continu.

Comme nous l'avons déjà signalé précédemment, la réalisation pratique d'un filtrage d'un signal temporel impose une limitation du nombre d'échantillons du signal à filtrer et de la fonction de transfert qui sont impliqués dans les opérations qui viennent d'être décrites. La figure 2 illustre un filtrage classique effectué dans le domaine fréquentiel où le nombre d'échantillons est limité à la valeur N. Dans ce cas, le signal temporel continu e(t) se présente sous la forme d'un vecteur ou bloc d'échantillons [e(n)] obtenu par exemple par un échantillonnage à la période T suivi d'une conversion analogique-numérique A/N et d'une conversion série-parallèle S-P portant sur N échantillons successifs e(nT). La fonction de transfert H du filtre étant elle-même supposée échantillonnée sur N échantillons, elle se présente également sous la forme d'un bloc d'échantillons [H(k)]. Le filtrage proprement dit consiste alors à effectuer en parallèle les produits des échantillons H(k) de la fonction de transfert H par ceux de même rang E(k) représentant la transformée de Fourier discrète des signaux temporels échantillonnés e(n). Cette transformée de Fourier discrète TFD opère sur N échantillons [e(n)] du signal temporel et peut être réalisée au moyen d'un circuit mettant en oeuvre un algorithme du type "transformation de Fourier rapide" ou FFT ("Fast Fourier Transform"). Les produits S(k) des échantillons E(k) par H(k) définissent la transformée de Fourier discrète du signal temporel de sortie s(n) résultant du filtrage. Le signal temporel de sortie est obtenu par une transformation de Fourier discrète inverse $TFD^{-1}$ opérant sur chaque bloc de N produits [S(k)]. Une conversion parallèle-série P-S au rythme de la période d'échantillonnage T fournit le signal temporel S(t) aux instants t = nT.

On constate que la complexité du filtre à réaliser est directement liée à la taille des opérateurs exécutant les transformations de Fourier discrètes directe et inverse, c'est-à-dire au nombre N d'échantillons traités par ces opérateurs. Par exemple, on peut démontrer que le nombre de multiplications nécessaires pour réaliser une transformée de Fourier rapide de taille N est égal à N. $\log_2(N)$. Ainsi, on a donc tout intérêt à choisir un nombre N le plus petit possible qui soit compatible avec les conditions (1) et (4) définies précédemment. Il conviendra cependant que l'échantillonnage de la fonction de transfert H du filtre satisfasse aussi aux conditions (2) et (3).

Dans le cas où l'on dispose d'une fonction de transfert H définie dans le domaine fréquentiel avec une très grande précision, c'est-à-dire par un très grand nombre d'échantillons H(K) séparé par un pas d'échantillonnage fréquentiel df très faible, ces échantillons ne peuvent pas être utilisés directement car les conditions (1) à (4) ne sont généralement pas satisfaites. En d'autres termes, cela signifie que l'horizon temporel 1/df du filtre défini par sa fonction de transfert H(K) est supérieur à l'horizon temporel N.T qui serait suffisant pour filtrer le signal. Si l'on suppose par exemple que l'inverse 1/df du pas d'échantillonnage df de la fonction de transfert H est un multiple L de l'horizon temporel NT, l'utilisation directe des échantillons H(K) nécessiterait normalement de prévoir des transformations de Fourier discrètes de taille LN, ce qui reviendrait à les surdimensionner inutilement.

Le problème est donc le suivant. On dispose d'une fonction de transfert H définie sur un nombre L.N d'échantillons H(K) alors qu'il suffirait de filtrer le signal temporel e(n) sur N échantillons seulement. L'invention a pour but de rechercher un procédé de filtrage utilisant une fonction de transfert H1 définie sur N échantillons H1(k) et pouvant représenter avec une précision suffisante la fonction de transfert H, définie sur L.N échantillons H(K).

Dans ce but, l'invention propose un procédé de filtrage par une fonction de transfert d'un signal temporel numérique échantillonné avec une période d'échantillonnage T et représenté par sa transformée de Fourier discrète définie par blocs de N échantillons dans le domaine fréquentiel, ladite fonction de transfert étant échantillonnée dans le domaine fréquentiel et définie pour un nombre L.N d'échantillons, L étant un nombre entier supérieur ou égal à 2, caractérisé en ce que, préalablement au traitement du signal temporel, est calculée une fonction de transfert partielle définie dans le domaine fréquentiel par les étapes suivantes :

- définition d'une fonction dans le domaine temporel, appelée fenêtre temporelle, de valeur non nulle à l'intérieur d'un intervalle de temps de durée égale à N fois la période d'échantillonnage T et prenant une valeur nulle ou tendant vers zéro à l'extérieur dudit intervalle,

- calcul du produit de convolution cyclique sur L.N échantillons de ladite fonction de transfert échantillonnée par la transformée de Fourier discrète de ladite fenêtre temporelle,

- sous-échantillonnage dudit produit de convolution dans le rapport L de façon à définir N échantillons de ladite fonction de transfert partielle,

et en ce que sont effectués en temps réel les produits respectivement desdits échantillons de ladite fonction de transfert partielle par les échantillons de même rang de ladite transformée de Fourier discrète dudit signal temporel.

On peut avantageusement définir la fenêtre temporelle par une fonction échantillonnée dans le domaine temporel et dans ce cas, selon un autre aspect de l'invention, le produit de convolution cyclique consiste à effectuer un calcul de la transformée de Fourier discrète inverse de ladite fonction de transfert échantillonnée, à effectuer les produits respectivement des échantillons de ladite transformée de Fourier discrète inverse par les échantillons de même rang de ladite fenêtre temporelle échantillonnée et à calculer la transformée de Fourier discrète desdits produits.

Selon un autre aspect de l'invention, la fenêtre temporelle est choisie de sorte que son intégrale par rapport au temps soit égale à N fois la période d'échantillonnage T.

Le procédé qui vient d'être défini permet en fait d'ajuster l'horizon temporel du filtre à celui du signal temporel à filtrer lorsque la fonction de transfert H initiale du filtre est trop finement définie pour les besoins du filtrage. Il en résulte une optimisation de la taille et de la complexité des circuits de transformation de Fourier discrète (tels que FFT et FFT$^{-1}$) qui doivent fonctionner en temps réel. Toujours dans le but de réduire la taille de ces circuits, ce problème est lié à un problème complémentaire pouvant être formulé de la façon suivante. On dispose d'une fonction de transfert sous la forme d'échantillons avec un pas d'échantillonnage fréquentiel df donné. Pour filtrer un signal temporel, on souhaite utiliser des transformations de Fourier discrètes de taille réduite N alors que l'horizon temporel du signal normalement nécessaire au filtrage est supérieur à NT mais inférieur à 1/df. On a vu précédemment comment réduire l'horizon temporel du filtre. Il reste maintenant à trouver une solution permettant d'augmenter l'horizon temporel sans augmenter la taille N des circuits de transformation de Fourier discrète.

L'invention a également pour objet un procédé de filtrage permettant de résoudre ce problème. Plus précisément, l'invention concerne un procédé de filtrage par une fonction de transfert d'un signal temporel numérique échantillonné avec une période d'échantillonnage T et représenté par sa transformée de Fourier discrète définie par blocs de N échantillons dans le domaine fréquentiel, ladite fonction de transfert étant échantillonnée dans le domaine fréquentiel et définie pour un nombre L.N d'échantillons, L étant un nombre entier supérieur ou égal à 2, caractérisé en ce que, préalablement au traitement du signal temporel, sont calculées M fonctions de transfert partielles, définies dans le domaine fréquentiel par les étapes suivantes :

- définition de M intervalles de temps successifs ayant chacun une durée égale à N fois la période d'échantillonnage T,

- pour chacun desdits intervalles, définition dans le domaine temporel d'une fonction, appelée fenêtre temporelle, de valeur non nulle à l'intérieur de l'intervalle de temps associé et prenant une valeur nulle ou tendant vers zéro à l'extérieur dudit intervalle,

- calcul des produits de convolution cyclique sur L.N échantillons de ladite fonction de transfert échantillonnée par respectivement les transformées de Fourier discrètes desdites fenêtres temporelles,

- sous-échantillonnage desdits produits de convolution dans le rapport L de façon à définir N échantillons de chacune desdites fonctions de transfert partielles,

et en ce qu'est effectuée en temps réel la somme de signaux fréquentiels partiels organisés en M blocs de N échantillons et résultant respectivement des produits des échantillons desdites M fonctions de transfert partielles par des échantillons de même rang de M blocs successifs de N échantillons de ladite transformée de Fourier discrète du signal temporel.

Selon une variante exploitant les propriétés de linéarité des transformées de Fourier, l'invention concerne également un procédé de filtrage par une fonction de transfert d'un signal temporel numérique échantillonné avec une période d'échantillonnage T et représenté par sa transformée de Fourier discrète définie par blocs de N échantillons dans le domaine fréquentiel, ladite fonction de transfert étant échantillonnée dans le domaine fréquentiel et définie pour un nombre L.N d'échantillons, L étant un nombre entier supérieur ou égal à 2, caractérisé en ce que, préalablement au traitement du signal temporel, sont calculées M fonctions de transfert partielles, définies dans le domaine fréquentiel par les étapes suivantes :

- définition de M intervalles de temps successifs ayant chacun une durée égale à N fois la période d'échantillonnage T,

- pour chacun desdits intervalles, définition dans le domaine temporel d'une fonction, appelée fenêtre temporelle, de valeur non nulle à l'intérieur de l'intervalle de temps associé et prenant une valeur nulle ou tendant vers zéro à l'extérieur dudit intervalle,

- calcul des produits de convolution cyclique sur L.N échantillons de ladite fonction de transfert échantillonnée par respectivement les transformées de Fourier discrètes desdites fenêtres temporelles,

- sous-échantillonnage desdits produits de convolution dans le rapport L de façon à définir N échantillons de chacune desdites fonctions de transfert partielles

et en ce qu'est effectuée en temps réel la somme de signaux fréquentiels partiels organisés en M blocs de N échantillons et résultant respectivement de M produits successifs des échantillons desdites M fonctions de transfert partielles par les échantillons de même rang de N échantillons de ladite transformée de Fourier discrète du signal temporel.

L'invention permet donc de décomposer une fonction de transfert définie sur un nombre quelconque d'échantillons en un banc de filtres élémentaires définis chacun sur un nombre plus réduit d'échantillons. Il en résulte que la complexité globale des circuits nécessaires est inférieure à celle qui résulterait de l'utilisation directe des échantillons de la fonction de transfert initiale.

L'invention a également pour objet l'application du procédé de filtrage qui vient d'être défini pour la correction d'échos dans un canal de transmission. Dans ce cas, le filtrage porte sur un signal temporel numérique échantillonné présent au niveau d'un récepteur relié audit canal de transmission, ladite fonction de transfert étant déterminée à partir du calcul de l'inverse de la fonction de transfert dans le domaine fréquentiel dudit canal.

L'invention a également pour objet un filtre numérique pour la mise en oeuvre du procédé selon l'invention. Ce filtre est caractérisé en ce qu'il comporte un calculateur numérique programmé pour calculer lesdits échantillons de ladite fonction de transfert partielle et muni d'une interface de sortie permettant de délivrer lesdits échantillons, et en ce que ledit filtre comporte des circuits câblés pour calculer ladite transformée de Fourier discrète du signal temporel ainsi que le produit desdits échantillons de ladite fonction de transfert partielle par les échantillons de même rang de ladite transformée de Fourier discrète du signal temporel.

Dans le cas d'une réalisation en banc de filtres, le filtre selon l'invention est caractérisé en ce qu'il comporte un calculateur numérique programmé pour calculer lesdits échantillons desdites fonctions de transfert partielles et muni d'une interface de sortie permettant de délivrer lesdits échantillons, et en ce que ledit filtre comporte des circuits câblés pour calculer ladite transformée de Fourier discrète du signal temporel ainsi que les produits desdits échantillons desdites fonctions de transfert partielles par les échantillons de même rang de ladite transformée de Fourier discrète du signal temporel.

D'autres aspects, détails de réalisation et avantages de l'invention apparaîtront dans la suite de la description en référence aux figures.

- Les figures 1 et 2 sont des schémas de principe en vue d'introduire les différents signaux utilisés ;

- la figure 3 est un schéma de principe du procédé selon l'invention ;

- la figure 4 représente les principaux éléments constitutifs du filtre selon l'invention ;

- la figure 5 représente les éléments du banc de filtres selon l'invention pour définir des fonctions de transfert partielles ;

- la figure 6 représente des diagrammes définissant les fenêtres temporelles utilisées dans le banc de filtres de la figure 5 ;

- les figures 7 à 9 représentent plusieurs variantes de réalisation du banc de filtres selon l'invention ;

- la figure 10 représente les signaux d'horloge servant à synchroniser le circuit représenté à la figure 9 ;

- les figures 11 à 13 sont des schémas illustrant l'application du filtre selon l'invention pour la correction d'échos dans un canal de transmission.

Pour faciliter la compréhension de la suite des explications, nous utiliserons par convention la notation suivante :

- L, M et N sont des entiers, avec $M \leq L$ ;

- les signaux ou fonctions de transfert (réponses impulsionnelles) sont en minuscules lorsqu'ils sont exprimés dans le domaine temporel et en majuscules dans le domaine fréquentiel ;

- n ou m désignent le rang de l'échantillon courant d'un signal ou d'une réponse impulsionnelle dans le domaine temporel, avec $o \leq n \leq N - 1$ et $o \leq m \leq LN - 1$ ;

- k ou K désignent le rang d'un échantillon courant d'un signal ou d'une réponse impulsionnelle dans le domaine fréquentiel, avec $o \leq k \leq N - 1$ et $o \leq K \leq LN - 1$ ;

- les références entre crochets désignent des blocs d'échantillons de taille N ou LN selon qu'ils renferment respectivement les symboles de rang n, k ou m, K.

Les figures 1 et 2 ont servi à montrer les différentes grandeurs susceptibles d'être impliquées dans un filtrage numérique classique. Dans ce cas, le nombre N d'échantillons H(k) définissant la fonction de transfert H du filtre est égal à celui des échantillons e(n) ou e(k) du signal temporel définit dans le domaine temporel ou fréquentiel. Pour se ramener à ce cas lorsque l'on dispose d'un nombre supérieur LN d'échantillons H(K) de la fonction de transfert H définie dans le domaine fréquentiel, on réalise conformément à l'invention un traitement de ces échantillons de façon à définir une nouvelle fonction de transfert H1 représentée par N échantillons H1 (k). Cette transformation est illustrée à la figure 3.

Elle consiste tout d'abord à définir dans le domaine temporel une fenêtre temporelle g1 pouvant être représentée par une fonction prenant la valeur 1 (à un coefficient d'échelle près) à l'intérieur d'un intervalle de temps de durée égale à N fois la période d'échantillonnage T. On effectue alors le produit de convolution de la fonction de transfert échantillonnée [H(K)] par la transformée de Fourier discrète [G1(K)] de cette fenêtre temporelle g1 de façon à obtenir LN échantillons [H1(K)]. On effectue ensuite un sous-échantillonnage de [H1(K)] dans le rapport L de façon à obtenir la fonction de transfert désirée H1 définie sur N échantillons H1(k). En appliquant ces échantillons [H1(k)] à l'entrée [H(k)] du filtre représenté à la figure 2, on obtient le filtrage désiré du signal temporel e(t) défini sur l'horizon temporel NT.

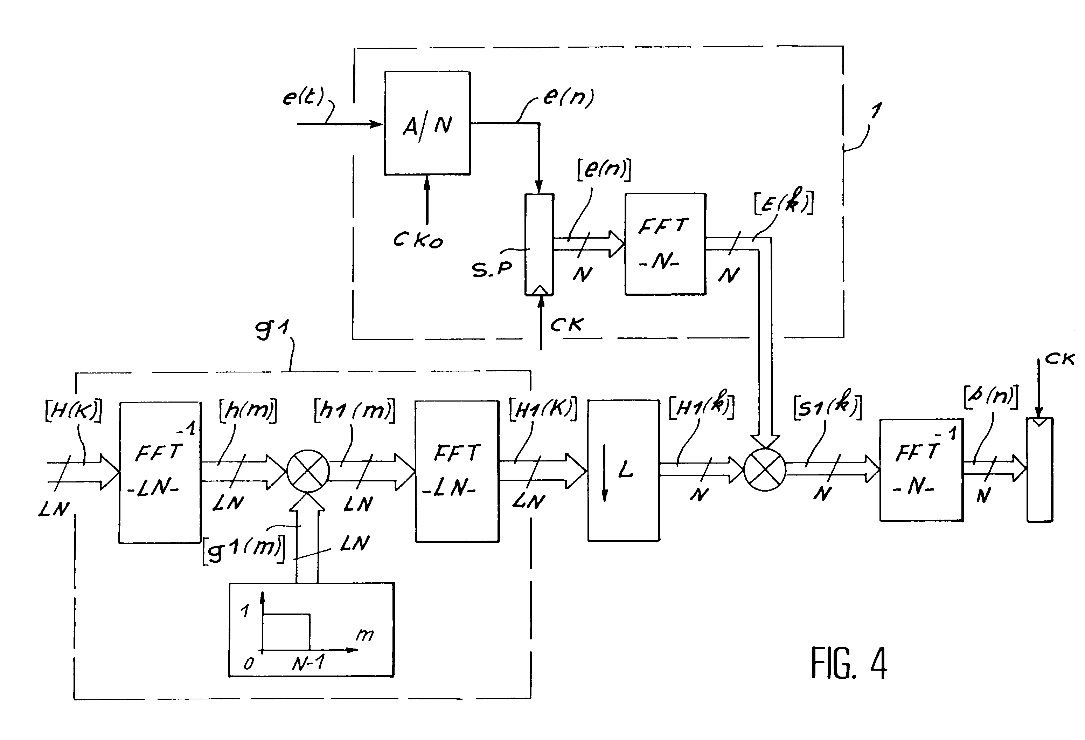

La figure 4 est un schéma d'ensemble d'une variante du filtre mettant en oeuvre le procédé précédent. Le filtre comporte un circuit 1 pour calculer en temps réel la transformée de Fourier discrète définie par blocs [E(k)] de N échantillons du signal temporel e(t) à filtrer. Le circuit 1 comporte un convertisseur analogique-numérique A/N recevant le signal temporel continu e(t) et séquencé par un signal d'horloge CK0 de période T. Le convertisseur A/N fournit à chaque période T le signal échantillonné e(n) appliqué à l'entrée d'un convertisseur série-parallèle S-P synchronisé par un signal d'horloge CK de période NT de façon à fournir des blocs de N échantillons [e(n)]. En traitant ce bloc par un circuit de transformation de Fourier discrète FFT-N de dimension N, on obtient la transformée de Fourier discrète [E(k)]. Bien entendu, le circuit 1 serait superflu si l'on disposait par d'autres moyens des échantillons E(k).

La figure 4 montre également une façon particulière de réaliser la convolution de la fonction de transfert initiale [H(K)] par la fenêtre temporelle g1 définie précédemment. Selon cette réalisation, la fenêtre temporelle g1 est sous la forme d'une fonction échantillonnée g1(m) définie sur LN échantillons dans le domaine temporel. On calcule alors par une transformée de Fourier inverse la réponse impulsionnelle [h(m)] de [H(K)]. On peut utiliser par exemple un opérateur du type "transformée de Fourier rapide inverse" FFT$^{-1}$-LN de dimension LN. Cette transformation fournit LN échantillons [h(m)] qui sont multipliés par les échantillons de même rang de la fenêtre temporelle échantillonnée [g1(m)]. Une transformation de Fourier FFT-LN de ces produits [h1(m)] fournit LN échantillons [H1(K)]. Comme précédemment, ces échantillons sont sous-échantillonnés dans un rapport L de façon à fournir N échantillons [H1(k)].

Le circuit comporte des multiplieurs pour effectuer en parallèle et en temps réel les produits des échantillons H1(k) par les échantillons de même rang k de la transformée de Fourier discrète E(k) du signal temporel. Ces produits fournissent les échantillons [S1(k)] qui constituent la transformée de Fourier discrète du signal de sortie du filtre. A partir des échantillons [S1(k)], on peut obtenir le signal de sortie échantillonné dans le domaine temporel s(n) au moyen d'une transformation de Fourier discrète inverse FFT$^{-1}$-N.

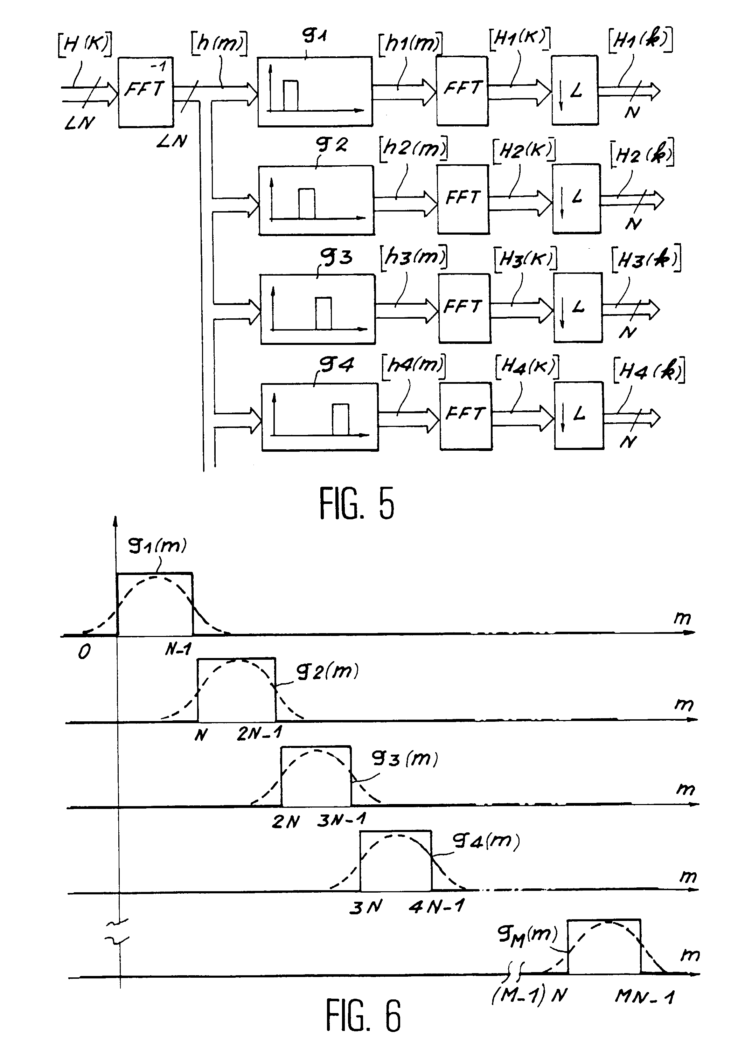

La figure 5 représente une généralisation du filtre précédent sous la forme d'un banc de filtres réalisant une décomposition de la fonction de transfert initiale H(K) en M fonctions de transfert partielles H1, ..., H4, ... définies chacune sur N échantillons, avec M ≤ L. On définit pour cela M fenêtres temporelles g1, g2, ..., g$_M$ telles que représentées sur le diagramme de la figure 6. Chacune de ces fenêtres correspond à un horizon temporel de largeur NT et la juxtaposition de M fenêtres adjacentes permet donc de définir un horizon temporel de largeur M.NT. Il est à noter que les fenêtres temporelles ne sont pas nécessairement des fenêtres rectangulaires mais peuvent avoir l'allure représentée en pointillés sur le diagramme de façon à déborder de part et d'autre de la fenêtre rectangulaire de référence tout en conservant la même surface. Cette disposition permet en particulier d'éviter des difficultés lors de la recomposition du signal de sortie à partir des signaux de sortie partiels obtenus par le filtrage du signal temporel d'entrée par les fonctions de transfert partielles H1, H2, ..., H$_M$.

Pour chacun des étages du banc de filtres, on effectue les opérations qui ont été décrites en référence aux figures 3 et 4. Ainsi, selon une première possibilité, on calcule pour chaque étage le produit de convolution cyclique de la fonction de transfert H(K) par la transformée de Fourier discrète G1(K), ..., G4(K), ... de la fenêtre temporelle g1, ..., g4, ... de l'étage considéré. Selon une autre possibilité, le produit de convolution est obtenu par le calcul de la transformée de Fourier discrète inverse h(m) de la fonction de transfert H(K) suivi du calcul des produits h1(m), ..., h4(m), ... respectivement des échantillons h(m) par les échantillons de même rang de chaque fenêtre temporelle échantillonnée g1(m), ..., g4(m), ... définie dans le domaine temporel. Un calcul de la transformée de Fourier discrète de ces produits h1(m), ..., h4(m), ... fournit les blocs d'échantillons [H1(K)], ..., [H4(K)], ... .

Comme précédemment, les échantillons H1(K), ..., H4(K), ... subissent un sous-échantillonnage de rapport L pour fournir les fonctions de transfert partielles H1(k), ..., H4(k), ... recherchées.

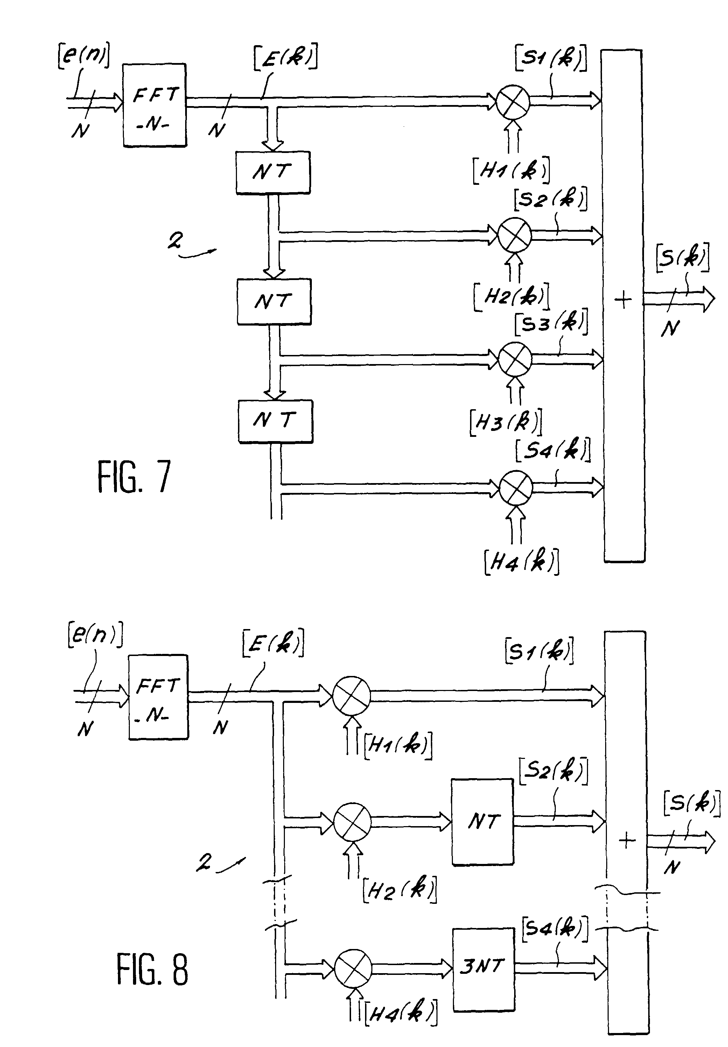

Les fonctions de transfert partielles H1, ..., H4, ... peuvent être utilisées pour reconstituer un signal de sortie défini par blocs de N échantillons seulement mais prenant en compte un horizon temporel supérieur à NT. La façon de réaliser cette recomposition par une cellule de filtrage va maintenant être décrite en référence aux figures 7 à 10.

Selon une première possibilité représentée à la figure 7, la cellule de filtrage 2 constitue M blocs successifs de N échantillons de la transformée de Fourier discrète [E(k)] au moyen de circuits à retard montés par exemple en registre décalage. Ces circuits à retard fournissent en sortie des blocs décalés les uns par rapport aux autres d'un intervalle de temps égal à NT. M multiplieurs effectuent les produits des échantillons des fonctions de transfert partielles [H1(k)], ..., [H4(k)] ... par les échantillons de même rang des blocs successifs issus des circuits à retard. Les multiplieurs fournissent en sortie M blocs de signaux fréquentiels partiels de N échantillons [S1(k)], [S4(k)], ... qui sont ensuite sommés en parallèle dans un additionneur dont la sortie fournit N échantillons de la transformée de Fourier discrète S(k) du signal de sortie du filtre.

Il est important de noter que si l'on prend M = L, on réalise un filtrage sur un horizon temporel du signal d'entrée égal à l'horizon temporel de la fonction de transfert initiale H(K).

La figure 8 représente une seconde variante de réalisation de la cellule de filtrage 2, fonctionnellement équivalente à celle de la figure 7. Ces deux réalisations se distinguent l'une de l'autre par le fait que les produits et les retards sont permutés.

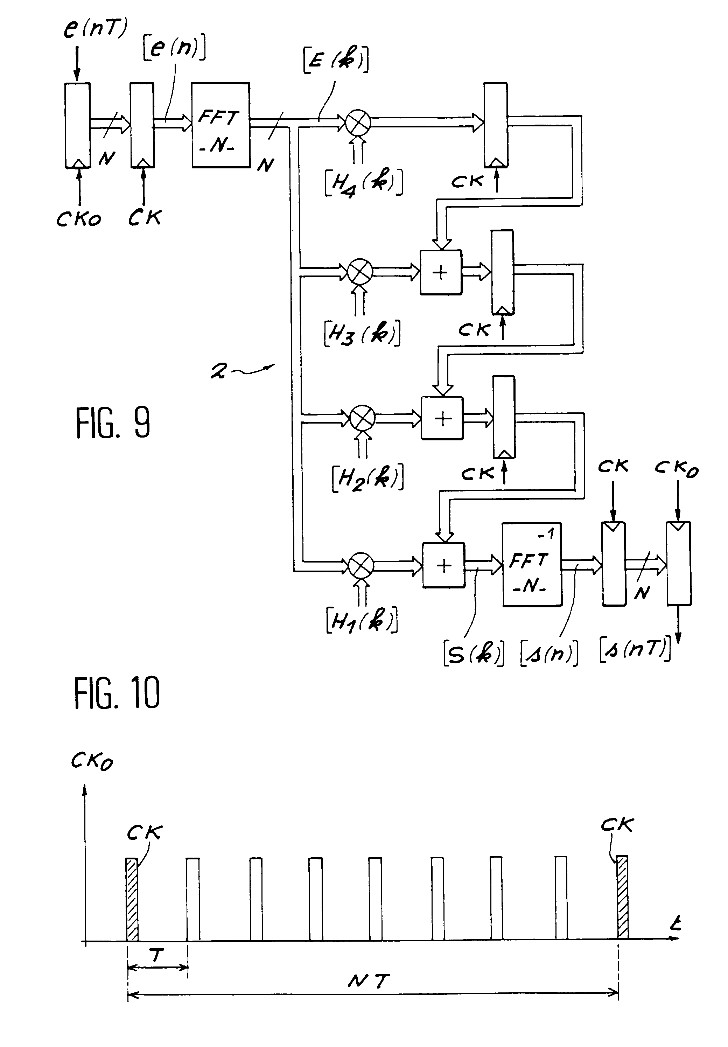

Selon une autre variante représentée à la figure 9 et correspondant à titre d'exemple à un banc de filtres à quatre étages, les opérations de retard et de sommation sont alternées de façon à remplacer la sommation de M blocs d'échantillons par une succession de sommations de deux blocs seulement. Ceci présente l'avantage de simplifier la réalisation des sommateurs et par conséquent de réduire le temps de calcul.

Le fonctionnement du circuit de la figure 9 se déduit immédiatement du schéma et du chronogramme de la figure 10 qui montre le signal d'horloge d'échantillonnage CK0 et le signal d'horloge de blocs CK utilisé pour synchroniser le circuit.

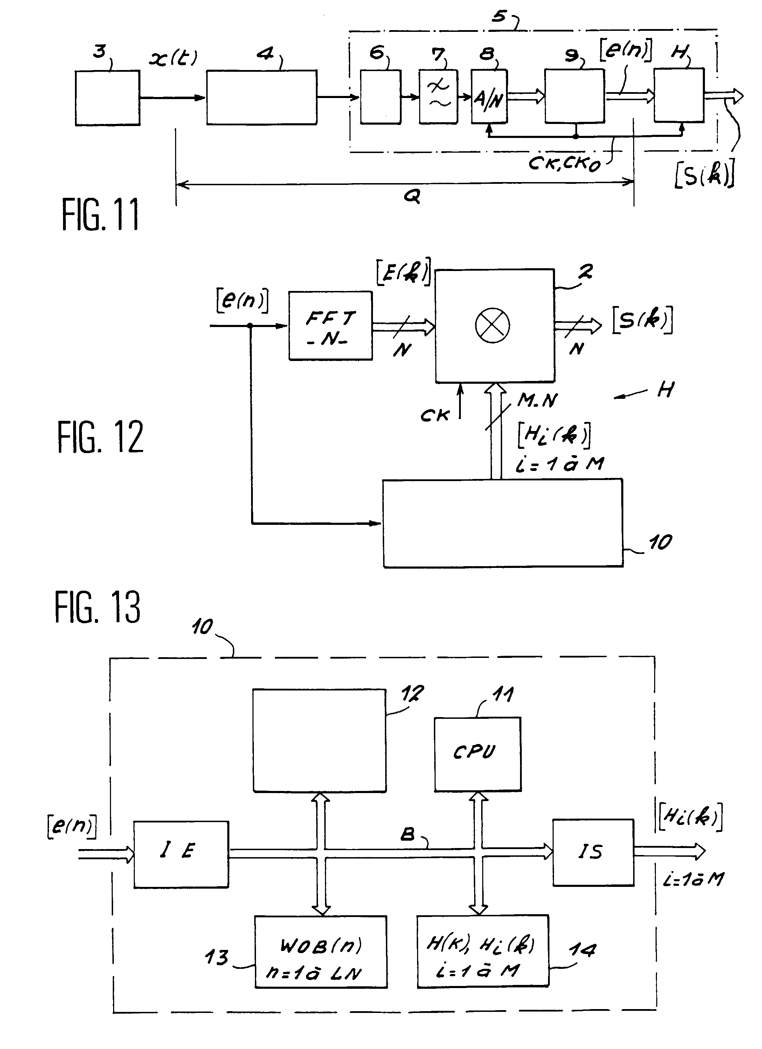

Pour illustrer une application particulièrement intéressante du procédé de filtrage selon l'invention, la figure 11 représente un schéma général d'un exemple de système de transmission de données, tel qu'un système de transmission d'images de télévision.

De façon classique, le système est constitué d'un émetteur 3, d'un réseau de transmission 4 et d'un récepteur 5. Le récepteur 5 est constitué du montage en cascade d'un démodulateur 6, d'un filtre passe-bas 7, d'un convertisseur analogique-numérique 8 associé à un égaliseur 9 et éventuellement d'un filtre H de correction d'échos avantageusement réalisé conformément à l'invention. L'égaliseur 9 est prévu à la fois pour la récupération du signal d'horloge du signal reçu et pour réaliser une suppression des échos dits "courts" qui sont inévitablement produits dans l'ensemble du canal de transmission Q. La suppression des échos courts par l'égaliseur 9 a cependant pour contrepartie la création d'échos dits "longs" qui bien que très atténués nuisent à la qualité de l'image. C'est la raison pour laquelle il est utile de prévoir le filtre supplémentaire H destiné à supprimer ces échos longs. Cependant le traitement des échos longs suppose par définition que le filtre H devra prendre en compte un horizon temporel important du signal à filtrer. C'est pourquoi le procédé et le filtre selon l'invention sont particulièrement bien adaptés pour résoudre ce problème sans nécessité de prévoir des filtres volumineux.

La figure 12 représente une réalisation d'ensemble du filtre H utilisable notamment pour la correction d'échos longs. Il est essentiellement composé d'une cellule de filtrage 2 conforme à l'invention relié d'une part à un calculateur 10 et au signal d'entrée [e(n)] par l'intermédiaire d'un circuit de transformation de Fourier rapide FFT-N. Le calculateur 10 reçoit le signal d'entrée en vue de calculer la fonction de transfert Q du canal à partir d'un signal de wobulation transmis par l'émetteur 3. Le signal de wobulation permet au calculateur de calculer avec une bonne précision la fonction de transfert échantillonnée dans le domaine fréquentiel du canal Q. Le calculateur peut alors calculer l'inverse de cette fonction Q pour obtenir la fonction de transfert du filtre H après une correction éventuelle en vue d'assurer la stabilité du filtre. Avantageusement, le calculateur 10 pourra mettre en oeuvre un algorithme d'adaptation permettant d'ajuster régulièrement les coefficients de la fonction de transfert calculée. On utilisera par exemple la ligne 624 du signal D2-MAC pour transmettre le signal de wobulation.

Enfin, le calculateur sera programmé pour calculer les coefficients des fonctions de transfert partielles H1, ..., H4, ... conformément au procédé selon l'invention. Bien entendu, on pourra utiliser le même calculateur avec une cellule 2 réduite à un multiplieur si une seule fonction de transfert H1 suffit. Dans le cas contraire, il faudra prévoir M fonctions de transfert partielles et une cellule 2 prévue en conséquence de sorte que le produit M.N.T. soit au moins égal à la longueur de l'écho à corriger.

A titre d'exemple de réalisation, la figure 13 montre les principaux éléments constitutifs du calculateur 10. Le calculateur est organisé autour d'un bus B sur lequel sont connectés un processeur 11, une mémoire de programme 12, une première mémoire 13 pour contenir les échantillons WOB(n) du signal de wobulation et une seconde mémoire 14 prévue pour contenir les coefficients calculés du filtre H ainsi que ceux des fonctions de transfert partielles Hi. Une interface d'entrée IE et une interface de sortie IS permettent au bus B de communiquer avec respectivement le signal d'entrée [e(n)] et les multiplieurs de la cellule de filtrage 2.

Le calculateur qui vient d'être décrit étant de type classique, sa constitution détaillée et son fonctionnement ne nécessitent pas d'explications supplémentaires compte tenu des indications déjà données précédemment.

Cette réalisation mixte qui combine un calculateur programmé 10 pour le calcul des coefficients et des circuits cablés pour le traitement en temps réel du signal vise à optimiser les coûts de réalisation tout en satisfaisant aux critères de performance.

**Revendications**

1. Procédé de filtrage par une fonction de transfert (H) d'un signal temporel numérique ([e(n)]) échantillonné avec une période d'échantillonnage T et représenté par sa transformée de Fourier discrète ([E(k)]) définie par blocs de N échantillons dans le domaine fréquentiel, ladite fonction de transfert (H) étant échantillonnée ([H(K)]) dans le domaine fréquentiel et définie pour un nombre L.N d'échantillons, L étant un nombre entier supérieur ou égal à 2, caractérisé en ce que, préalablement au traitement du signal temporel ([e(n)]), est calculée une fonction de transfert partielle ([H1(k)]) définie dans le domaine fréquentiel par les étapes suivantes :

    - définition d'une fonction dans le domaine temporel, appelée fenêtre temporelle (g1), de valeur non nulle à l'intérieur d'un intervalle de temps de durée égale à N fois la période d'échantillonnage T et prenant une valeur nulle ou tendant vers zéro à l'extérieur dudit intervalle,

    - calcul du produit de convolution cyclique ([H1(K)]) sur L.N échantillons de ladite fonction de transfert échantillonnée ([H(K)]) par la transformée de Fourier discrète ([G1(K)]) de ladite fenêtre temporelle (g1),

    - sous-échantillonnage dudit produit de convolution ([H1(K)]) dans le rapport L de façon à définir N échantillons de ladite fonction de transfert partielle ([H1(k)]),

    et en ce que sont effectués en temps réel les produits ([S1(k)]) respectivement desdits échantillons de ladite fonction de transfert partielle ([H1(k)]) par les échantillons de même rang de ladite transformée de Fourier discrète ([E(k)]) dudit signal temporel ([e(n)]).

2. Procédé de filtrage selon la revendication 1, caractérisé en ce que ladite fenêtre temporelle (g1) étant une fonction échantillonnée, ledit produit de convolution cyclique ([H1(k)]) consiste à effectuer un calcul de la transformée de Fourier discrète inverse ([h(m)]) de ladite fonction de transfert échantillonnée ([H(K)]), à effectuer les produits ([h1(m)]) respectivement des échantillons de ladite transformée de Fourier discrète inverse ([h(m)]) par les échantillons de même rang de ladite fenêtre temporelle échantillonnée (g1) et à calculer la transformée de Fourier discrète ([H1(K)]) desdits produits ([h1(m)]).

3. Procédé de filtrage selon l'une des revendications 1 ou 2 caractérisé en ce que ladite fenêtre temporelle (g1) est choisie de sorte que son intégrale par rapport au temps soit égale à N fois la période d'échantillonnage T.

4. Procédé de filtrage par une fonction de transfert (H) d'un signal temporel numérique ([e(n)]) échantillonné avec une période d'échantillonnage T et représenté par sa transformée de Fourier discrète ([E(k)]) définie par blocs de N échantillons dans le domaine fréquentiel, ladite fonction de transfert (H) étant échantillonnée ([H(K)]) dans le domaine fréquentiel et définie pour un nombre L.N d'échantillons, L étant un nombre entier supérieur ou égal à 2, caractérisé en ce que, préalablement au traitement du signal temporel ([e(n)]), sont calculées M fonctions de transfert partielles ([H1(k)], ..., [H4(k)]) définies dans le domaine fréquentiel par les étapes suivantes :

    - définition de M intervalles de temps successifs ayant chacun une durée égale à N fois la période d'échantillonnage T,

    - pour chacun desdits intervalles, définition dans le domaine temporel d'une fonction, appelée fenêtre temporelle (g1, ..., g4), de valeur non nulle à l'intérieur de l'intervalle de temps associé et prenant une valeur nulle ou tendant vers zéro à l'extérieur dudit intervalle,

    - calcul des produits de convolution cyclique ([H1(K), ..., H4(K)]) sur L.N échantillons de ladite fonction de transfert échantillonnée ([H(K)]) par respectivement les transformées de Fourier discrètes ([G1(K), ..., G4(K)]) desdites fenêtres temporelles (g1, ..., g4),

    - sous-échantillonnage desdits produits de convolution ([H1(K), ..., H4(K)]) dans le rapport L de façon à définir (g1, ..., g4) N échantillons de chacune desdites fonctions de transfert partielles ([H1(k), ..., H4(k)])

    et en ce qu'est effectuée en temps réel la somme de signaux fréquentiels partiels organisés en M blocs de N échantillons ([S1(k), ..., S4(k)]) et résultant respectivement des produits des échantillons desdites M fonctions de transfert partielles ([H1(k), ..., H4(k)]) par des échantillons de même rang de M blocs successifs de N échantillons de ladite transformée de Fourier discrète ([E(k)]) du signal temporel ([e(n)]).

5. Procédé de filtrage par une fonction de transfert (H) d'un signal temporel numérique ([e(n)]) échantillonné avec une période d'échantillonnage T et représenté par sa transformée de Fourier discrète ([E(k)]) définie par blocs de N échantillons dans le domaine fréquentiel, ladite fonction de transfert (H) étant échantillonnée ([H(K)]) dans le domaine fréquentiel et définie pour un nombre L.N d'échantillons, L étant un nombre entier supérieur ou égal à 2, caractérisé en ce que, préalablement au traitement du signal temporel ([e(n)]), sont calculées M fonctions de transfert partielles ([H1(k)], ..., [H4(k)]) définies dans le domaine fréquentiel par les étapes suivantes :

- définition de M intervalles de temps successifs ayant chacun une durée égale à N fois la période d'échantillonnage T,

- pour chacun desdits intervalles, définition dans le domaine temporel d'une fonction, appelée fenêtre temporelle (g1, ..., g4), de valeur non nulle à l'intérieur de l'intervalle de temps associé et prenant une valeur nulle ou tendant vers zéro à l'extérieur dudit intervalle,

- calcul des produits de convolution cyclique ([H1(K), ..., H4(K)]) sur L.N échantillons de ladite fonction de transfert échantillonnée ([H(K)]) par respectivement les transformées de Fourier discrètes ([G1(K), ..., G4(K)]) desdites fenêtres temporelles (g1, ..., g4),

- sous-échantillonnage desdits produits de convolution ([H1(K), ..., H4(K)]) dans le rapport L de façon à définir (g1, ..., g4) N échantillons de chacune desdites fonctions de transfert partielles ([H1(k), ..., H4(k)])

et en ce qu'est effectuée en temps réel la somme de signaux fréquentiels partiels organisés en M blocs de N échantillons ([S1(k), ..., S4(k)]) et résultant respectivement de M produits successifs des échantillons desdites M fonctions de transfert partielles ([H1(k), ..., H4(k)]) par les échantillons de même rang de N échantillons de ladite transformée de Fourier discrète ([E(k)]) du signal temporel ([e(n)]).

6. Procédé de filtrage selon l'une des revendications 4 ou 5, caractérisé en ce que lesdites fenêtres temporelles (g1, ..., g4) étant des fonctions échantillonnées, chacun desdits produits de convolution cyclique ([H1(k)]) consiste à effectuer un calcul de la transformée de Fourier discrète inverse ([h(m)]) de ladite fonction de transfert échantillonnée ([H(K)]), à effectuer les produits ([h1(m)]) respectivement des échantillons de ladite transformée de Fourier discrète inverse ([h(m)]) par les échantillons de même rang de chacune desdites fenêtres temporelles échantillonnées (g1) et à calculer la transformée de Fourier discrète ([H1(K)]) desdits produits ([h1(m)]).

7. Procédé de filtrage selon l'une des revendications 4 à 6, caractérisé en ce que chacune desdites fenêtres temporelles est choisie de façon à ce que son intégrale par rapport au temps soit égale à N fois la période d'échantillonnage T et de sorte que la somme de deux fenêtres adjacentes soit égale à l'unité.

8. Méthode de correction d'échos dans un canal de transmission par application du procédé de filtrage selon l'une des revendications 1 à 7, caractérisée en ce que le filtrage porte sur un signal temporel numérique échantillonné présent au niveau d'un récepteur relié audit canal de transmission, ladite fonction de transfert (H) étant déterminée à partir du calcul de l'inverse de la fonction de transfert (Q) dans le domaine fréquentiel dudit canal.

9. Méthode de correction selon la revendication 8, caractérisée en ce que ladite fonction de transfert du canal est déterminée au moyen d'un signal de wobulation produit par un émetteur relié à l'autre extrémité dudit canal.

10. Méthode de correction d'échos dans un canal de transmission par application du procédé de filtrage selon l'une des revendications 4 à 7, caractérisée en ce que ledit signal temporel numérique ([e(n)]) est un signal présent au niveau d'un récepteur relié à une extrémité dudit canal, en ce que ladite fonction de transfert (H) est l'inverse de la fonction de transfert (Q) dudit canal, en ce que lesdits M intervalles de temps sont adjacents et en ce que les nombres M et N sont choisis de façon à ce que le produit M.N.T soit au moins égal à la longueur de l'écho à corriger.

11. Filtre numérique pour la mise en oeuvre du procédé de filtrage selon l'une des revendications 1 à 3, caractérisé en ce qu'il comporte un calculateur numérique programmé pour calculer lesdits échantillons de ladite fonction de transfert partielle ([H1(k)]) et muni d'une interface de sortie permettant de délivrer lesdits échantillons, et en ce que ledit filtre comporte des circuits câblés pour calculer ladite transformée de Fourier discrète ([E(k)]) du signal temporel ([e(n)]) ainsi que le produit desdits échantillons de ladite fonction de transfert partielle ([H1(k)]) par les échantillons de même rang de ladite transformée de Fourier discrète ([E(k)]) du signal temporel ([e(n)]).

12. Filtre numérique pour la mise en oeuvre du procédé de filtrage selon l'une des revendications 4 à 7, caractérisé en ce qu'il comporte un calculateur numérique programmé pour calculer lesdits échantillons desdites fonctions de transfert partielles ([H1(k)]) et muni d'une interface de sortie permettant de délivrer lesdits échantillons, et en ce que ledit filtre comporte des circuits câblés pour calculer ladite transformée de Fourier discrète ([E(k)]) du signal temporel ([e(n)]) ainsi que les produits desdits échantillons desdites fonctions de transfert partielles ([H1(k)]) par les échantillons de même rang de ladite transformée de Fourier discrète ([E(k)]) du signal temporel ([e(n)]).

**Patentansprüche**

1. Verfahren zum Filtern eines digitalen Zeitsignals ([e(n)]), das mit einer Abtastperiode T abgetastet wird und durch seine durch Blöcke von N Abtastwerten im Frequenzbereich definierte diskrete Fourier-Transformation ([E(k)]) repräsentiert wird, mittels einer Übertragungsfunktion (H), die im Frequenzbereich abgetastet ([H(K)]) wird und durch eine Anzahl L · N von Abtastwerten definiert ist, wobei L eine ganze Zahl größer oder gleich 2 ist, dadurch gekennzeichnet, daß vor der Verarbeitung des Zeitsignals ([e(n)]) eine Partialübertragungsfunktion ([H1(k)]) berechnet wird, die im Frequenzbereich durch die folgenden Stufen definiert wird:

   - Definition einer Funktion im Zeitbereich, die Zeitfenster (g1) genannt wird und innerhalb eines Zeitintervalls mit einer Dauer, die gleich der N-fachen Abtastperiode T ist, einen von Null verschiedenen Wert besitzt und außerhalb dieses Intervalls einen Wert Null oder einen nach Null strebenden Wert annimmt,

   - Berechnung des zyklischen Faltungsprodukts ([H1(K)]) an L · N Abtastwerten der abgetasteten Übertragungsfunktion ([H(k)]) mit der diskreten Fourier-Transformation ([G1(K)]) des Zeitfensters (g1),

   - Unterabtastung des Faltungsprodukts ([H1(K)]) im Verhältnis L, derart, daß N Abtastwerte der Partialübertragungsfunktion ([H1(k)]) definiert werden,

   und dadurch, daß die Produkte ([S1(k)]) der Abtastwerte der Partialübertragungsfunktion ([H1(k)]) mit den entsprechenden Abtastwerten gleichen Rangs der diskreten Fourier-Transformation ([E(k)]) des Zeitsignals ([e(n)]) in Echtzeit ausgeführt werden.

2. Filterungsverfahren nach Anspruch 1, dadurch gekennzeichnet, daß das zyklische Faltungsprodukt ([H1(k)]) dann, wenn das Zeitfenster (g1) eine abgetastete Funktion ist, darin besteht, eine Berechnung der inversen diskreten Fourier-Transformation ([h(m)]) der abgetasteten Übertragungsfunktion ([H(K)]) auszuführen, die Produkte ([h1(m)]) der Abtastwerte der inversen diskreten Fourier-Transformation ([h(m)]) mit den entsprechenden Abtastwerten gleichen Rangs des abgetasteten Zeitfensters (g1) auszuführen und die diskrete Fourier-Transformation ([H1(K)]) der Produkte ([h1(m)]) zu berechnen.

3. Filterungsverfahren nach einem der Ansprüche 1 oder 2, dadurch gekennzeichnet, daß das Zeitfenster (g1) in der Weise gewählt wird, daß sein Integral über die Zeit gleich der N-fachen Abtastperiode T ist.

4. Verfahren zum Filtern eines digitalen Zeitsignals ([e(n)]), das mit einer Abtastperiode T abgetastet wird und durch seine durch Blöcke von N Abtastwerten im Frequenzbereich definierte diskrete Fourier-Transformation ([E(k)]) repräsentiert wird, mittels einer Übertragungsfunktion (H), die im Frequenzbereich abgetastet ([H(K)]) wird und durch eine Anzahl L · N von Abtastwerten definiert ist, wobei L eine ganze Zahl größer oder gleich 2 ist, dadurch gekennzeichnet, daß vor der Verarbeitung des Zeitsignals ([e(n)]) M Partialübertragungsfunktionen ([H1(k)], ..., [H4(k)]) berechnet werden, die im Frequenzbereich durch die folgenden Stufen definiert werden:

   - Definition von M aufeinanderfolgenden Zeitintervallen, wovon jedes eine Dauer besitzt, die gleich der N-fachen Abtastperiode T ist,

   - für jedes der Intervalle Definition einer Funktion im Zeitbereich, die Zeitfenster (g1, ..., g4) genannt wird und innerhalb des zugeordneten Zeitintervalls einen von Null verschiedenen Wert besitzt und außerhalb des Intervalls einen Wert Null oder einen nach Null strebenden Wert annimmt,

   - Berechnung von zyklischen Faltungsprodukten ([H1(K), ..., H4(K)]) an L · N Abtastwerten der abgetasteten Übertragungsfunktion ([H(K)]) mit den entsprechenden diskreten Fourier-Transformationen ([G1(K), ..., G4(K)]) der Zeitfenster (g1, ... g4),

   - Unterabtastung der Faltungsprodukte ([H1(K), ..., H4(K)]) im Verhältnis L, derart, daß N Abtastwerte jeder der Partialübertragungsfunktionen ([H1(k), ..., H4(k)]) definiert werden (g1, ..., g4),

   und dadurch, daß die Summe der Partialfrequenzsignale, die in M Blöcken aus N Abtastwerten ([S1(k), .., S4(k)]) organisiert sind und sich entsprechend aus den Produkten der Abtastwerte der M Partialübertragungsfunktionen ([H1(k), ..., H4(k)]) mit den Abtastwerten gleichen Rangs von M aufeinanderfolgenden Blöcken von N Abtastwerten der diskreten Fourier-Transformation ([E(k)]) des Zeitsignals ([e(n)]) ergeben, in Echtzeit ausgeführt wird.

5. Verfahren zum Filtern eines digitalen Zeitsignals ([e(n)]), das mit einer Abtastperiode T abgetastet wird und durch seine durch Blöcke von N Abtastwerten im Frequenzbereich definierte diskrete Fourier-Transformation ([E(k)]) repräsentiert wird, mittels einer Übertragungsfunktion (H), die im Frequenzbereich abgetastet ([H(K)]) wird und durch eine Anzahl L · N von Abtastwerten definiert ist, wobei L eine ganze Zahl größer oder gleich 2 ist, dadurch gekennzeichnet, daß vor der Verarbeitung des Zeitsignals ([e(n)]) M Partialübertragungsfunktionen ([H1(k)], ..., [H4(k)]) berechnet werden, die im Frequenzbereich durch die folgenden Stufen definiert werden:

   - Definition von M aufeinanderfolgenden Zeitintervallen, wovon jedes eine Dauer besitzt, die gleich der N-fachen Abtastperiode T ist,

   - für jedes der Intervalle Definition einer Funktion im Zeitbereich, die Zeitfenster (g1, ..., g4) genannt wird und innerhalb des zugeordneten Zeitintervalls einen von Null verschiedenen Wert besitzt und außerhalb des Intervalls einen Wert Null oder einen nach Null strebenden Wert annimmt,

   - Berechnung von zyklischen Faltungsprodukten ([H1(K), ..., H4(K)]) an L · N Abtastwerten der abgetasteten Übertragungsfunktion ([H(K)]) mit den entsprechenden diskreten Fourier-Transformationen ([G1(K), ..., G4(K)]) der Zeitfenster (g1, ..., g4),

   - Unterabtastung der Faltungsprodukte ([H1(K),... H4(K)]) im Verhältnis L, derart, daß N Abtastwerte jeder der Partialübertragungsfunktionen ([H1(k), ..., H4(k)]) definiert werden (g1, ..., g4),

   und dadurch, daß die Summe aus den Partialfrequenzsignalen, die in M Blöcken aus N Abtastwerten ([S1(k), ..., S4(k)]) organisiert sind und sich entsprechend aus M aufeinanderfolgenden Produkten von Abtastwerten der M Partialübertragungsfunktionen ([H1(k), ..., H4(k)]) mit den Abtastwerten gleichen Rangs von N Abtastwerten der diskreten Fourier-Transformation ([E(k)]) des Zeitsignals ([e(n)]) ergeben, in Echtzeit ausgeführt wird.

6. Filterungsverfahren nach einem der Ansprüche 4 oder 5, dadurch gekennzeichnet, daß jedes der zyklischen Faltungsprodukte ([H1(k)]) dann, wenn die Zeitfenster (g1, ..., g4) abgetastete Funktionen sind, darin besteht, eine Berechnung der inversen diskreten Fourier-Transformation ([h(m)]) der abgetasteten Übertragungsfunktion ([H(K)]) auszuführen, die Produkte ([h1(m)]) der Abtastwerte der inversen diskreten Fourier-Transformation ([h(m)]) mit den entsprechenden Abtastwerten gleichen Rangs jedes der abgetasteten Zeitfenster (g1) auszuführen und die diskrete Fourier-Transformation ([H1(K)]) der Produkte ([h1(m)]) zu berechnen.

7. Filterungsverfahren nach einem der Ansprüche 4 bis 6, dadurch gekennzeichnet, daß jedes der Zeitfenster in der Weise gewählt wird, daß sein Integral über die Zeit gleich der N-fachen Abtastperiode T ist, und derart, daß die Summe aus zwei benachbarten Fenstern gleich Eins ist.

8. Verfahren zum Korrigieren von Echos in einem Übertragungskanal durch Anwenden des Filterungsverfahrens nach einem der Ansprüche 1 bis 7, dadurch gekennzeichnet, daß sich die Filterung auf ein abgetastetes digitales Zeitsignal stützt, das auf Höhe eines mit dem Übertragungskanal verbundenen Empfängers vorhanden ist, wobei die Übertragungsfunktion (H) ausgehend von der Berechnung der inversen Übertragungsfunktion (Q) im Frequenzbereich des Kanals bestimmt wird.

9. Korrekturverfahren nach Anspruch 8, dadurch gekennzeichnet, daß die Übertragungsfunktion des Kanals mittels eines Wobbelsignals, das durch einen mit dem anderen Ende des Kanals verbundenen Empfänger erzeugt wird, bestimmt wird.

10. Verfahren zum Korrigieren von Echos in einem Übertragungskanal durch Anwenden des Filterungsverfahrens nach einem der Ansprüche 4 bis 7, dadurch gekennzeichnet, daß das digitale Zeitsignal ([e(n)]) ein Signal ist, das auf Höhe eines mit einem Ende des Kanals verbundenen Empfängers vorhanden ist, daß die Übertragungsfunktion H die inverse Übertragungsfunktion (Q) des Kanals ist, daß die M Zeitintervalle benachbart sind und daß die Anzahl M und die Anzahl N in der Weise gewählt werden, daß das Produkt M · N · T wenigstens gleich der Länge des zu korrigierenden Echos ist.

11. Digitales Filter für die Ausführung des Filterungsverfahrens nach einem der Ansprüche 1 bis 3, dadurch gekennzeichnet, daß es einen digitalen Rechner enthält, der in der Weise programmiert ist, daß er die Abtastwerte der Partialübertragungsfunktion ([H1(k)]) berechnet, und mit einer Ausgangsschnittstelle versehen ist, die die Ausgabe der Abtastwerte ermöglicht, und daß das Filter Schaltungen enthält, die so verdrahtet sind, daß die diskrete Fourier-Transformation ([E(k)]) des Zeitsignals ([e(n)]) sowie das Produkt der Abtastwerte der Partialübertragungsfunktion ([H1(k)]) mit den Abtastwerten gleichen Rangs der diskreten Fourier-Transformation ([E(k)]) des Zeitsignals ([e(n)]) berechnet werden.

12. Digitales Filter für die Ausführung des Filterungsverfahrens nach einem der Ansprüche 4 bis 7, dadurch gekennzeichnet, daß es einen digitalen Rechner enthält, der in der Weise programmiert ist, daß er die Abtastwerte der Partialübertragungsfunktionen ([H1(k)]) berechnet, und mit einer Ausgangsschnittstelle versehen ist, die die Ausgabe der Abtastwerte ermöglicht, und daß das Filter Schaltungen enthält, die in der Weise verdrahtet sind, daß die diskrete Fourier-Transformation ([E(k)]) des Zeitsignals ([e(n)]) sowie die Produkte der Abtastwerte der Partialübertragungsfunktionen ([H1(k)]) mit den Abtastwerten gleichen Rangs der diskreten Fourier-Transformation ([E(k)]) des Zeitsignals ([e(n)]) berechnet werden.

## Claims

1. Method of filtering by a transfer function (H) a digital time signal ([e(n)]) sampled over a sampling period T and represented by its discrete Fourier transform ([E(k)]) defined by blocks of N samples in the frequency domain, the said transfer function (H) being sampled ([H(K)]) in the frequency domain and defined for a number L.N samples, where L is a whole number greater than or equal to 2, characterised in that, prior to processing the time signal ([e(n)]), a partial transfer function ([H1(k)]) defined in the frequency domain is calculated by the following steps :

   - a function is defined in the time domain, known as the time window (g1), having a value that is not zero inside a time period of a duration equal to N times the sampling period T and having a zero value or a value tending to zero outside the said period,

   - over L.N samples of the said sampled transfer function ([H(K)]), the periodic convolution product ([H1(K)]) is calculated by the discrete Fourier transform ([G1(K)]) of the said time window (g1),

   - the said convolution product ([H1(K)]) is sub-sampled in the ratio L so as to define N samples of the said partial transfer function ([H1(k)]),

   and the products ([S1(k)]) are found in real time of the said samples of the said partial transfer function ([H1(k)]) by the respective samples of equal rank of the said discrete Fourier transform ([E(k)]) of the said time signal ([e(n)]).

2. Method of filtering as claimed in claim 1, characterised in that since the said time window (g1) is a sampled function, the said periodic convolution product ([H1(k)]) is found by calculating the inverse discrete Fourier transform ([h(m)]) of the said sampled transfer function ([H(K)]), finding the products ([h1(m)]) of the respective samples of the said inverse discrete Fourier transform ([h(m)]) by the samples of equal rank in the said time window sampled (g1) and calculating the discrete Fourier transform ([H1(K)]) of the said products ([h1(m)]).

3. Method of filtering as claimed in one of claims 1 or 2, characterised in that the said time window (g1) is selected such that its integral relative to the time is equal to N times the sampling period T.

4. Method of filtering by a transfer function (H) a digital time signal ([e(n)]) sampled over a sampling period T and represented by its discrete Fourier transform (E(k)]) defined by blocks of N samples in the frequency domain, the said transfer function (H) being sampled (H(K)]) in the frequency domain and defined for a number L.N of samples, where L is a whole number greater than or equal to 2, characterised in that prior to processing the time signal ([e(n)]), M partial transfer functions defined in the frequency domain are calculated by the following steps:

   - M successive time periods are defined, each being of a duration equal to N times the sampling period T,

   - for each of the said periods, a function is defined in the time domain, known as the time window (g1,..., g4), of a value that is not zero inside the respective time period and having a value of zero or tending towards zero outside the said period,

   - calculating the periodic convolution products ([H1(K), ..., H4(K)]) over L.N samples of the said transfer function sampled ([H(K)]) by the respective discrete Fourier transforms ([G1(K), ..., G4(K)]) of the said time windows (g1, ..., g4),

   - the said convolution products ([H1(K), ..., H4(K)]) are sub-sampled in the ratio L so as to define (g1, ..., g4) N samples of each of the said partial transfer functions ([H1(k), ..., H4(k)])

   and partial frequency signals organised in M blocks of N samples ([S1(k), ..., S4(k)]) and resulting respectively from the products of the samples of the said M partial transfer functions ([H1(k), ..., H4(k)]) are summed in real time by samples of equal rank of M successive blocks of N samples of the said discrete Fourier transform ([E(k)]) of the time signal ([e (n)]).

5. Method of filtering by a transfer function (H) a digital time sample ([e(n)]) sampled over a sampling period T and represented by its discrete Fourier transform ([E(k)]) defined by blocks of N samples in the frequency domain, the said transfer function (H) being sampled ([K(K)]) in the frequency domain and defined for a number L.N of samples, where L is a whole number greater than or equal to 2, characterised in that prior to processing the time signal ([e (n)]), M partial transfer functions ([H1(k)], ..., [H4(k)] defined in the frequency domain are calculated by the following steps:

- M successive time periods are defined, each being of a duration equal to N times the sampling period,

- for each of the said periods, a function, referred to as the time window (g1, ..., g4), is defined in the time domain, having a value that is not zero inside the time associated with the time period and having a value of zero or tending towards zero outside the said period,

- the periodic convolution products ([H1(K), ..., H4(K)]) are calculated over L.N samples of the said transfer function sampled ([H(K)]) by the respective discrete Fourier transforms ([G1 (K), ..., G4(K)]) of the said time windows (g1, ..., g4),

- the said convolution products ([H1(K), ..., H4 (K)]) are sub-sampled in the ratio L so as to define (g1, ..., g4) N samples of each of the said partial transfer functions ([H1(k), ..., H4(k)])

and partial frequency signals organised in M blocks of N samples ([S(k), ..., S4(k)] and resulting respectively from M successive products of samples of the said M partial transfer functions ([H1(k), ..., H4(k)]) are summed in real time by the samples of equal rank of N samples of the said discrete Fourier transform ([E(k)]) of the time signal ([e(n)]).

6. Method of filtering as claimed in one of claims 4 or 5, characterised in that since the said time windows (g1, ..., g4)are sampled functions, each of the said periodic convolution products ([H1(k)]) is found by calculating the inverse discrete Fourier transform ([h(m)]) of the said sampled transfer function ([H (K)]), finding the products (h1(m)]) of the respective samples of the said inverse discrete Fourier transform ([h(m)]) by samples of equal rank of each of the said sampled time windows (g1) and calculating the discrete Fourier transform ([H1(K)]) of the said products ([h1(m)]).

7. Method of filtering as claimed in one of claims 4 to 6, characterised in that each of the said time windows is selected such that its integral relative to the time is equal to N times the sampling period T and such that the sum of two adjacent windows is equal to the unit.

8. Method of applying the filtering process as claimed in one of claims 1 to 7 by correcting echos in a transmission channel characterised in that a sampled digital time signal present at the level of a receiver linked to the said transmission channel is filtered, the said transfer function (H) being determined by calculating the inverse transfer function (Q) in the frequency domain of the channel.

9. Correction method as claimed in claim 8, characterised in that the said transfer function of the channel is determined by means of a tracking signal produced by a transmitter linked to the other end of the said channel.

10. Method of applying the filtering method as claimed in one of claims 4 to 7 by correcting echos in a transmission channel, characterised in that the said digital time signal (e(n)]) is a signal present at the level of a receiver linked to one end of the said channel, the transfer function (H) is the inverse transfer function (Q) of the said channel, the said M time periods are adjacent and the numbers M and N are selected such that the product M.N.T. is at least equal to the length of the echo to be corrected.

11. Digital filter for implementing the filtering method as claimed in one of claims 1 to 3, characterised in that it has a digital computer programmed to calculate the said samples of the said partial transfer function ([H1(k)]) and provided with an output interface to supply the said samples, and the said filter has wired circuits to calculate the said discrete Fourier transform ([E(k)]) of the time signal ([e(n)]) as well as the product of the said samples of the said partial transfer function ([H1(k)]) by the samples of equal rank of the said discrete Fourier transform ([E(k)]) of the time signal ([e(n)]).

12. Digital filter for implementing the filtering method as claimed in one of claims 4 to 7, characterised in that it has a digital computer programmed to calculate the said samples of the said partial transfer functions ([H1(k)]) and provided with an output interface to supply the said samples, and the said filter has wired circuits to calculate the said discrete Fourier transform ([E)k)]) of the time signal ([e(n)]) as well as the products of the said samples of the said partial transfer functions by the samples of equal rank of the said discrete Fourier transform ([E(k)]) of the time signal ([e(n)]).

FIG. 1

FIG. 2

FIG. 3

FIG. 4

FIG. 5

FIG. 6

[e(n)] [E(k)] [S1(k)]

FFT
-N-

N N

NT

2

NT

[H1(k)]
[S2(k)]

[H2(k)]
[S3(k)]

NT

[H3(k)]
[S4(k)]

[S(k)]

+

N

[H4(k)]

FIG. 7

[e(n)] [E(k)] [S1(k)]

FFT
-N-

N N

[H1(k)]
[S2(k)]

NT

2

[H2(k)]

NT

[S4(k)]

3NT

[H4(k)]

[S(k)]

+

N

FIG. 8

FIG. 9

FIG. 10

FIG. 11

FIG. 12

FIG. 13